# EUROPÄISCHE PATENTSCHRIFT

(11) **EP 3 262 724 B1**
(45) Veröffentlichungstag und Bekanntmachung des Hinweises auf die Patenterteilung: **15.04.2020**
(21) Anmeldenummer: 16710681.4
(22) Anmeldetag: 25.02.2016
(51) Int. Cl.: H01R 13/6591, H05K 9/00, B60R 16/02

(54) **HV-KABELSATZ**
HIGH-VOLTAGE CABLE SET
FAISCEAU DE CÂBLES HAUTE TENSION

(30) Priorität: 27.02.2015 DE 202015100961 U
(43) Veröffentlichungstag der Anmeldung: 03.01.2018
(73) Patentinhaber: LEONI Bordnetz-Systeme GmbH, 97318 Kitzingen (DE)
(72) Erfinder: Albert, Volker, 97337 Dettelbach (DE); Hauschild, Wolfgang, 90513 Zirndorf (DE); Kett, Alexander, 92706 Luhe-Wildenau (DE); Ursprung, Felix, 97359 Schwarzach am Main (DE); Wolf, Sascha, 96050 Bamberg (DE)
(74) Vertreter: FDST Patentanwälte
(86) Internationale Anmeldenummer: PCT/EP2016/053952
(87) Internationale Veröffentlichungsnummer: WO 2016/135229

(56) Entgegenhaltungen:
- EP-A1- 2 579 405
- EP-A1- 2 582 222
- EP-A1- 2 610 878
- WO-A1-2013/118320
- DE-A1- 10 354 284
- DE-T5-112006 001 677
- JP-A- 2015 002 146
- US-A1- 2014 202 762

## Beschreibung

Die Erfindung betrifft einen HV-Kabelsatz.

Ein solcher HV-Kabelsatz, das heißt Hochspannungs-Kabelsatz findet beispielsweise Verwendung in einem Fahrzeugbordnetz, insbesondere bei einem Elektrofahrzeug, zur Anbindung einer HV-Komponente, das heißt Hochspannungskomponente. Eine übliche Verwendung ist das Verbinden einer elektrischen Antriebseinheit eines Elektrofahrzeugs mit einer Hochspannungsversorgung im Fahrzeugbordnetz. Unter Hochspannung wird hierbei insbesondere eine Spannung im Bereich von etwa 60 V bis 1000 V verstanden. Der HV-Kabelsatz umfasst endseitig typsicherweise einen Verbinder oder Anschluss, mittels dessen ein Anschließen an die jeweilige HV-Komponente erfolgt.

Zur Übertragung von elektrischer Leistung umfasst der HV-Kabelsatz ein oder mehrere Kabel. Um die Komponenten des Fahrzeuges vor elektromagnetischen Störeinflüssen aus der Umwelt und vor systembedingten eigenen Störspannungen zu schützen, sind die Kabel häufig mit einem gemeinsamen Schirm (auch als Summenschirm bezeichnet) umgeben. Dieser ist wiederum endseitig des HV-Kabelsatzes üblicherweise an ein elektrisches Massepotential angeschlossen, beispielsweise mittelbar über einen mit dem Massepotential verbundenen Verbinder, z.B. Hochvolt-Stecker, in welchen die einzelnen Kabel einlaufen. Der Schirm ist dann beispielsweise an ein Anschlussstück des Verbinders angecrimpt oder an diesem mittels eines Kabelbinders fixiert.

Für eine durchgängig optimale Schirmung muss der Schirm dauerhaft elektrisch kontaktiert und befestigt werden. Insbesondere aufgrund der mechanischen Beanspruchungen sowie wechselnden Witterungseinflüsse im Fahrzeugbereich ist eine möglichst haltbare Anbindung nötig. Problematisch ist hierbei insbesondere ein hoher Kontaktwiderstand, auch als Kontaktübergangswiderstand bezeichnet, aufgrund einer unzureichenden Anpresskraft, auch als Kontaktkraft bezeichnet. Ein hoher Kontaktwiderstand ergibt sich nachteilig insbesondere auch dann, wenn das Anschlussstück aus Aluminium gefertigt ist auf dessen Oberfläche eine entsprechende Oxidschicht ausgebildet ist. Zudem besteht am Übergang zwischen dem Schirm und dem Anschlussstück, welche häufig aus unterschiedlichen Materialien gefertigt sind, die Gefahr einer Kontaktkorrosion und einer damit einhergehenden Verschlechterung der Anbindung.

In der WO 2013/118320 A1 wird ein Geflechtschirm beschrieben, welcher an einer ovalen Schirmhülle befestigt wird. Die Schirmhülle weist zwei Teile auf, von welchen eines mit dem Geflechtschirm bedeckt wird und das andere darum herum angeordnet ist. Der Geflechtschirm ist zwischen den beiden Teilen durch eine Presspassung gesichert.

Ferner ist ein HV-Kabelsatz aus JP 2015-2146 A bekannt.

Vor diesem Hintergrund ist es eine Aufgabe der Erfindung, einen HV-Kabelsatz anzugeben, mit einem Schirm, insbesondere Summenschirm, dessen elektrische Anbindung insbesondere an eine Hochvolt-Komponente verbessert ist. Dabei soll insbesondere eine Anbindung mittels eines möglichst großen Anpressdrucks erfolgen.

Die Aufgabe wird erfindungsgemäß gelöst durch einen HV-Kabelsatz mit den Merkmalen gemäß Anspruch 1. Vorteilhafte Ausgestaltungen, Weiterbildungen und Varianten sind Gegenstand der Unteransprüche.

Der HV-Kabelsatz ist insbesondere zur Verwendung in einem Fahrzeugbordnetz vorgesehen sowie ausgelegt und umfasst eine Anzahl von Kabeln, die von einem gemeinsamen Schirm, insbesondere Masseschirm umgeben sind. Weiterhin umfasst der HV-Kabelsatz ein Anschlussstück aus einem leitenden Material, welches mit dem Schirm elektrisch verbunden ist, indem eine Klemmmanschette in einer Längsrichtung auf das Anschlussstück aufgeschoben ist und der Schirm zwischen einer ersten Klemmfläche des Anschlussstücks und einer zweiten Klemmfläche der Klemmmanschette eingeklemmt ist.

Ein wesentlicher mit der Erfindung erzielter Vorteil besteht insbesondere darin, dass mittels der Klemmmanschette eine Klemmzone ausgebildet wird, in welcher der Schirm besonders fest eingeklemmt ist. Durch das Aufschieben der Klemmmanschette in Längsrichtung, werden die erste und die zweite Klemmfläche auf besonders effektive Weise gegeneinander geschoben und der Schirm zwischen diesen beiden eingequetscht. Dadurch wird ein besonders dauerhafter Halt des Schirms realisiert, bei gleichzeitig besonders guter elektrischer Kontaktierung mit dem Anschlussstück. Ein weiterer Vorteil besteht insbesondere darin, dass beim Aufsetzen der Klemmmanschette durch Aneinanderreiben des Schirms und der Klemmflächen eine Aufrauhung und insbesondere auch eine Zerstörung einer möglicherweise vorhandenen Oxidschicht erfolgt, wodurch der Kontaktwiderstand insbesondere zwischen Schirm und Anschlussstück deutlich reduziert ist.

Die Kabel des HV-Kabelsatzes sind insbesondere Hochspannungskabel, zur Übertragung von elektrischer Leistung. Insbesondere ist der HV-Kabelsatz derart ausgebildet, dass diese Hochspannung mehrphasig übertragen wird, wobei jeweils eine Phase von einem Kabel übertragen wird. Beispielsweise ist der HV-Kabelsatz dann dreiphasig ausgebildet und umfasst entsprechend drei Kabel. Diese umfassen jeweils einen Leiter, welcher von einer geeigneten Isolierung umgeben ist. In Anbetracht des gemeinsamen Schirms wird auf eine separate Schirmung, d.h. insbesondere Einzelschirmung der Kabel insbesondere verzichtet.

Das Anschlussstück dient dem Anschluss des Schirms sowie insbesondere dessen Anbindung an ein elektrisches Massepotential. Das Anschlussstück ist dann beispielsweise ein entsprechend mit dem Massepotential verbundener Teil eines Verbinders, insbesondere Steckverbinders, eines Anschlussteils oder einer Durchführung oder alternativ ein Teil einer Hochvolt-Komponente, beispielsweise eines Leistungsverteilers, welcher entsprechend mit dem Massepotential verbunden ist. Dabei stellt das Anschlussstück insbesondere eine endseitige Begrenzung des Schirms dar. Der Schirm umgibt dann die Kabel lediglich bis zum Anschlussstück, in welches die Kabel entsprechend einlaufen. Hinter dem Anschlussstück erfolgt dann insbesondere eine Kontaktierung der Kabelenden mit entsprechenden Anschlüssen. Die auf diese Weise gebildete Anschlussstelle wird dann beispielsweise von einem Gehäuseteil umgeben, welches das Anschlussstück umfasst. Zum Einlaufen der Kabel umfasst das Anschlussstück entsprechend eine Durchführung, durch welche hindurch die Kabel verlaufen. Insbesondere ist in dieser Durchführung eine zusätzliche Zugentlastung für die Kabel untergebracht. Das Anschlussstück umläuft somit die Kabel.

Auf dem Anschlussstück ist dann die erste Klemmfläche als ein Teil der Oberfläche des Anschlussstücks ausgebildet. Gegen diese erste Klemmfläche wird dann der Schirm durch Aufschieben der Klemmmanschette verklemmt. Vorzugsweise ist das Anschlussstück aus Aluminium gefertigt und somit besonders kostengünstig in der Herstellung sowie ein geeigneter elektrischer Leiter.

Ähnlich dem Anschlussstück umläuft auch die Klemmmanschette die Kabel, d.h. die Kabel laufen durch eine Durchführung der Klemmmanschette hindurch. Diese ist dann zur Montage entlang der Kabel, d.h. in Längsrichtung verschiebbar, insbesondere derart, dass die eine der beiden Klemmflächen auf die andere aufgeschoben wird.

Der Schirm ist aus einem elektrisch leitendem Material gefertigt und beispielsweise als Geflecht ausgebildet, um eine besonders lückenlose und biegeflexible Schirmung der Kabel zur realisieren. Insbesondere ist der Schirm dabei nach Art eines Schlauches ausgebildet, welcher die Kabel umgibt. Endseitig ist der Schirm dann am Anschlussstück angebracht, insbesondere auf die erste Klemmfläche aufgeschoben. Die Klemmmanschette ist hierzu insbesondere derart angeordnet, dass diese die Anordnung aus Anschlussstück und darauf aufgeschobenem Schirm umläuft. In radialer Richtung, d.h. senkrecht zur Längsrichtung, ist dann der Schirm zwischen dem Anschlussstück und der Klemmmanschette angeordnet. Mit anderen Worten: Die beiden Klemmflächen sind in radialer Richtung überlappend angeordnet.

In einer bevorzugten Ausgestaltung sind die beiden Klemmflächen bezüglich der Längsrichtung in einem Winkel angestellt. Auf diese Weise wird insbesondere am Anschlussstück ein sich in Längsrichtung aufweitender Stutzen gebildet, auf welchen der Schirm in besonders geeigneter Weise aufschiebbar ist. Insbesondere im Falle eines als Geflecht ausgebildeten Schirms ergibt sich vorteilhaft eine Aufweitung des Schirms am Anschlussstück und dadurch ein besonders fester Halt. Durch das Anstellen der Klemmflächen wird auch eine bezüglich der Längsrichtung schiefe Ebene gebildet, welche beim Aufschieben der Klemmmanschette in Längsrichtung eine entsprechende Kraftübersetzung in radialer Richtung ermöglicht. Durch Aufschieben der Klemmmanschette in Längsrichtung wird dann in vorteilhafter Weise eine in radialer Richtung wirkende Klemmkraft erzeugt und hierdurch wiederum ein besonders geringer Kontaktwiderstand insbesondere zwischen Schirm und Anschlussstück erzielt.

Eine besonders optimale Übersetzung einer zum Aufschieben der Klemmmanschette in Längsrichtung aufgebrachten Kraft in die radiale Klemmkraft ergibt sich in einer geeigneten Weiterbildung insbesondere dadurch, dass der Winkel wenigstens 5 Grad und höchstens 45 Grad beträgt. Der Winkel bezeichnet dabei den von der jeweiligen Klemmfläche mit der Längsrichtung eingeschlossenen Winkel.

Vorzugsweise sind die Klemmflächen komplementär zueinander ausgebildet, d.h. insbesondere passgenau zueinander. Auf diese Weise wird eine optimale und besonders großflächige Klemmwirkung erzielt, insbesondere da die beiden Klemmflächen den Schirm hierbei besonders gleichmäßig einklemmen. Die beiden Klemmflächen stehen hierbei insbesondere parallel zueinander und bilden einen gleichmäßigen Zwischenraum, in welchem der Schirm entsprechend einsitzt.

In einer vorteilhaften Ausgestaltung sind die Klemmflächen jeweils konisch ausgebildet. Mit anderen Worten: Die Klemmflächen sind jeweils angestellt und umlaufen die Kabel, mit einem sich in Längsrichtung verjüngenden Querschnitt. Aufgrund dieser umlaufend angestellten Klemmflächen wird eine besonders gleichmäßige Klemmkraft in radialer Richtung erzielt, d.h. insbesondere in jeglicher Richtung senkrecht zur Längsrichtung. Entsprechend wird hierdurch eine umlaufend lückenlose Klemmverbindung geschaffen. Die konische Ausbildung stellt zudem eine besonders einfache Geometrie dar, wodurch das Anschlussstück und die Klemmmanschette besonders einfach zu fertigen sind.

Die Klemmmanschette ist mittels einer Anzahl von Schrauben an dem Anschlussstück befestigt. Auf diese Weise wird ein weiter verbesserter und besonders dauerhafter Halt gewährleistet. Zudem wird durch eine solche Schraubverbindung ein Abrutschen oder Lösen der Klemmmanschette besonders im Betrieb wirkungsvoll verhindert.

Die Schrauben sind in Längsrichtung in das Anschlussstück eingeschraubt. Insbesondere in Kombination mit den angestellten Klemmflächen ist es in dieser Ausgestaltung möglich, durch Anziehen der Schrauben in Längsrichtung die radiale Klemmkraft zur Fixierung des Schirms zu erzeugen. Zudem sind die in Längsrichtung angebrachten Schrauben besonders einfach zugänglich.

In einer geeigneten Weiterbildung weisen das Anschlussstück und die Klemmmanschette jeweils einen umlaufenden Flansch auf, d.h. insbesondere jeweils eine radiale Anlagefläche. Durch Aufschieben der Klemmmanschette in Längsrichtung werden dann die beiden Flansche zueinander gebracht und bieten einen besonders stabilen Halt der Klemmmanschette bezüglich des Anschlussstücks. Zudem bieten die Flansche auch genügend Raum zur Unterbringung der Schraubverbindungen.

Um insbesondere eine Kontaktkorrosion, d.h. die Bildung eines Lokalelements, zwischen Anschlussstück und Schirm zu vermeiden, sind diese vorzugsweise jeweils aus einem Material gefertigt, deren elektrochemische Standardpotentiale sich möglichst wenig, insbesondere um nicht mehr als 0,05 V voneinander unterscheiden. Die Wahl der miteinander in Verbindung gebrachten Materialien aufgrund von deren Standardpotentialen ermöglicht eine gezielte Reduzierung der Gefahr von Kontaktkorrosion. Durch Auswahl von Materialien, die in der elektrochemischen Spannungsreihe entsprechend nahe beieinanderliegen, wird die Kontaktkorrosion deutlich verringert. In einer besonders bevorzugten Ausgestaltung sind beide Materialien gleich gewählt, weisen also das gleiche Standardpotential auf, so dass eine Kontaktkorrosion insbesondere gänzlich vermieden ist. Bevorzugter Weise sind sowohl das Anschlussstück als auch der Schirm aus Aluminium gefertigt.

Vorzugsweise ist auch die Klemmmanschette aus einem Material gefertigt, dessen elektrochemisches Standardpotential sich möglichst wenig, insbesondere um nicht mehr als 0,05 V von dem des Materials des Masseschirms und/oder des Anschlussstücks unterscheidet. Vorzugsweise ist die Klemmmanschette aus dem gleichen Material gefertigt. Auf diese Weise wird auch eine Kontaktkorrosion zwischen Klemmmanschette und Anschlussstück bzw. Schirm vermieden. Generell geeignet ist auch eine alternative Ausführungsform, bei welcher die Klemmmanschette aus einem nicht leitenden Material, beispielsweise einem Kunststoff gefertigt ist.

Eine Kontaktkorrosion wird zudem insbesondere dadurch verhindert, dass die Klemmmanschette bezüglich des Schirms radial außenliegend angeordnet ist und entsprechend die Verbindungsstellen des Schirms mit dem Anschlussstück und der Klemmmanschette umläuft. Dadurch ist die Verbindung insbesondere optimal gegen von außen eindringende Feuchtigkeit und Schmutz geschützt, so dass ein zur Herstellung eines Lokalelements benötigtes Elektrolyt, beispielsweise Wasser, erst gar nicht eindringt.

In einer besonders kostengünstigen Ausgestaltung ist die Klemmmanschette als Tiefziehteil ausgebildet und dabei insbesondere nach Art eines Überwurfs für das Anschlussstück ausgeformt.

Vorzugsweise weist der HV-Kabelsatz insbesondere im Bereich der Klemmflächen zusätzlich eine Gehäuseschale auf, welche die Klemmmanschette einfasst. Auf diese Weise werden vorteilhaft mögliche Spalte oder Schlitze effektiv abgedichtet, so dass ein Eindringen von Feuchtigkeit und Schmutz optimal verhindert ist. Dadurch ist es insbesondere auch möglich, beispielsweise einen Schirm aus Kupfer mit einem Anschlussstück aus Aluminium zu verbinden und trotzdem eine Kontaktkorrosion zu vermeiden, da erst gar kein entsprechendes Elektrolyt zwischen die Klemmflächen gelangen kann.

Um insbesondere bei Verwendung von Aluminiumteilen den Kontaktwiderstand zwischen Schirm und Anschlussstück besonders gering zu halten, weist die erste Klemmfläche und insbesondere auch die zweite Klemmfläche eine aufgeraute Oberfläche auf, wodurch beim Festklemmen des Schirms mittels der Klemmmanschette eine auf der ersten Klemmfläche ausgebildete Oxidschicht besonders effizient aufgerissen wird und somit eine verbesserte elektrische Kontaktierung erfolgt. Unter aufgeraut wird dabei insbesondere verstanden, dass die Klemmfläche einen RA-Wert größer 0,4 µm aufweist.

In einer zweckmäßigen Ausgestaltung ist der HV-Kabelsatz über ein Anschlussteil an einer elektrischen HV-Komponente eines Fahrzeugs, insbesondere eines Elektrofahrzeugs angeschlossen. Das Anschlussteil dient hierbei insbesondere der Verbindung des HV-Kabelsatzes mit einem Gehäuse der HV-Komponente. Entsprechend bildet das Anschlussteil dann eine Durchführung für die Kabel des HV-Kabelsatzes in oder zur HV-Komponente. Dazu ist das Anschlussteil vorzugsweise dicht, sowie insbesondere auch elektrisch leitend mit dem Gehäuse der HV-Komponente verbunden. Die HV-Komponente ist beispielsweise ein Hochvoltspeicher oder eine Batterie des Fahrzeugs, eine elektrische Antriebsmaschine, ein Hochspannungsverteiler oder Hochvolt-Steckverbinder. Das Gehäuse der HV-Komponente ist dann mit dem Anschlussteil sowie mit dem Schirm mit einem gemeinsamen Potential, insbesondere einem Massepotential verbunden.

Nachfolgend wird ein Ausführungsbeispiel der Erfindung anhand einer Zeichnung näher erläutert. Darin zeigen schematisch:
- Fig. 1: ausschnittsweise einen HV-Kabelsatz,
- Fig. 2: die Anordnung gem. Fig. 1 in einer Explosionsdarstellung, und
- Fig. 3: den gesamten HV-Kabelsatz.

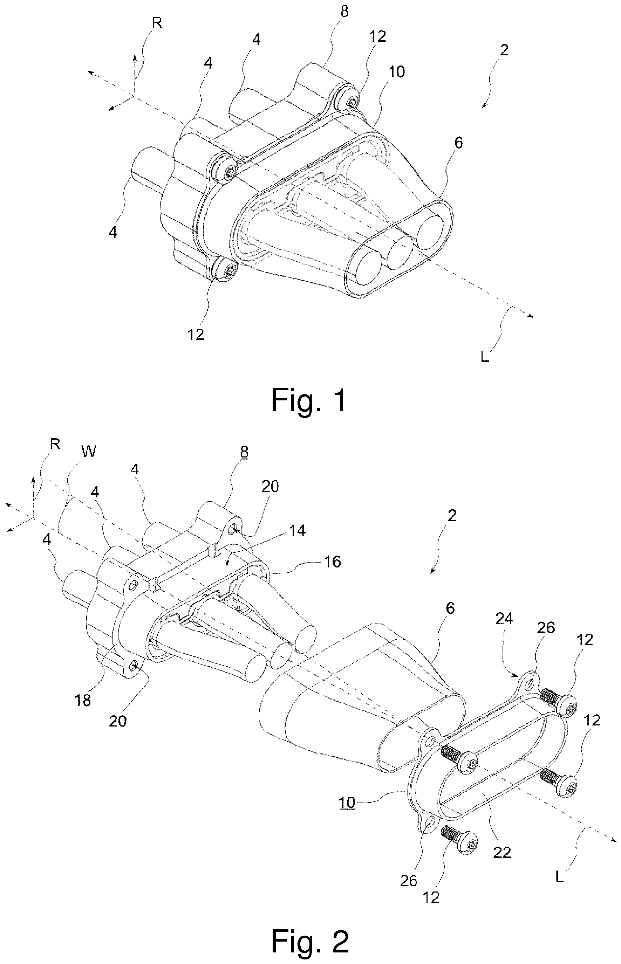

In Fig. 1 ist in einer Schrägansicht ein Ausschnitt eines HV-Kabelsatzes 2 dargestellt. Dieser ist zur Verwendung in einem nicht näher dargestellten Fahrzeugbordnetz ausgebildet und umfasst eine Anzahl von hier drei Kabeln 4, welche zur Übertragung von elektrischer Leistung ausgebildet sind. Diese Kabel 4 erstrecken sich in einer Längsrichtung L und sind von einem gemeinsamen Schirm 6, insbesondere Summenschirm umgeben. Dieser ist hier als Geflecht ausgeführt. Der Schirm 6 ist endseitig mit einem Anschlussstück 8 verbunden, durch welches die Kabel 4 hindurch laufen. Das Anschlussstück 8 ist hier insbesondere ein Teil eines in Fig. 1 nicht näher gezeigten Anschlussteils, mittels dessen der HV-Kabelsatz 2 an eine HV-Komponente eines Fahrzeugs anschließbar ist. Das Anschlussstück 8 ist zudem in hier nicht gezeigter Weise mit einem Massepotential elektrisch verbunden. Um in eingebautem Zustand des HV-Kabelsatzes 2 auch den Schirm 6 mit diesem Massepotential zu verbinden, ist dieser an das Anschlussstück 8 angeschlossen und mittels eines Klemmteils 10 besonders fest fixiert. Dabei ist das Klemmteil 10 mittels einer Anzahl von Schrauben 12 an das Anschlussstück 8 angeschraubt.

Die Wirkweise der Klemmmanschette 10 wird besonders in Kombination mit der in der Fig. 2 gezeigten Explosionsdarstellung der Anordnung aus Fig. 1 deutlich. Hierbei ist erkennbar, dass das Anschlussstück 8 eine bezüglich der Längsrichtung L in einem bestimmten Winkel W angestellte Klemmfläche 14 aufweist, auf welche der Schirm 6 aufsetzbar ist. In dem hier gezeigten Ausführungsbeispiel beträgt der Winkel W etwa 5°. Die Klemmfläche 14 ist hier konisch ausgeführt, d.h. weist quer zur Längsrichtung L einen sich in dieser Längsrichtung L verjüngenden Querschnitt auf. Dieser ist insbesondere umlaufend durchgängig ausgebildet. Das Anschlussstück 8 bildet auf diese Weise einen das Kabel 4 radial umlaufenden Stutzen 16 aus, dessen Oberfläche, d.h. die in radialer Richtung R nach außen weisende Fläche, die Klemmfläche 14 ist. An diese schließt sich in Längsrichtung L eine radiale Anlagefläche an, welche einen Flansch 18 des Anschlussstücks 8 bildet. In diesen sind eine Anzahl von Gewindelöchern 20 zur Aufnahme der Schrauben 12 eingebracht.

Die Klemmmanschette 10 ist hier als Tiefziehteil ausgebildet und umläuft ebenfalls die Kabel 4. Dabei weist die Klemmmanschette 10 eine radial nach innen weisende Innenfläche auf, welche eine zweite Klemmfläche 22 darstellt, und in dem hier gezeigten Ausführungsbeispiel komplementär zur ersten Klemmfläche 14 ausgebildet ist. In montiertem Zustand ist dann der Schirm 6 endseitig zwischen der ersten Klemmfläche 14 und der zweiten Klemmfläche 22 eingeklemmt. Aufgrund der konischen Ausgestaltung der beiden Klemmflächen 14, 22 wird durch Aufschieben in Längsrichtung L insbesondere eine Klemmkraft in radialer Richtung R erzeugt, durch welche der Schirm 6 besonders fest gehalten wird. Auch weist die Klemmmanschette 10 wie auch das Anschlussstück 8 eine radiale Anlagefläche als Flansch 24 auf, welcher in verbundenem Zustand an dem Flansch 18 des Anschlussstücks 8 anliegt. Der Flansch 24 dient hier insbesondere auch als Fläche zur Einbringung von Durchgangslöchern 26, durch welche die Schrauben 12 hindurchgeführt werden. Auf diese Weise ist es insbesondere möglich, die Schrauben 12 in Längsrichtung L anzuordnen.

In dem hier gezeigten Ausführungsbeispiel sind sowohl das Anschlussstück 8, als auch der Schirm 6 und die Klemmmanschette 10 aus Aluminium gefertigt. Dadurch wird eine Kontaktkorrosion insbesondere im Bereich der Klemmflächen 14, 22 besonders effizient vermieden. Zudem bietet die Klemmmanschette durch die umlaufende Ausgestaltung einen effektiven Schutz gegen das Eindringen von Feuchtigkeit, welche als Elektrolyt zur Ausbildung eines Lokalelements im Bereich der beiden Klemmflächen 14, 22 dienen könnte. Der HV-Kabelsatz 2 ist daher hier insbesondere auf zweifache Weise vor Kontaktkorrosion geschützt.

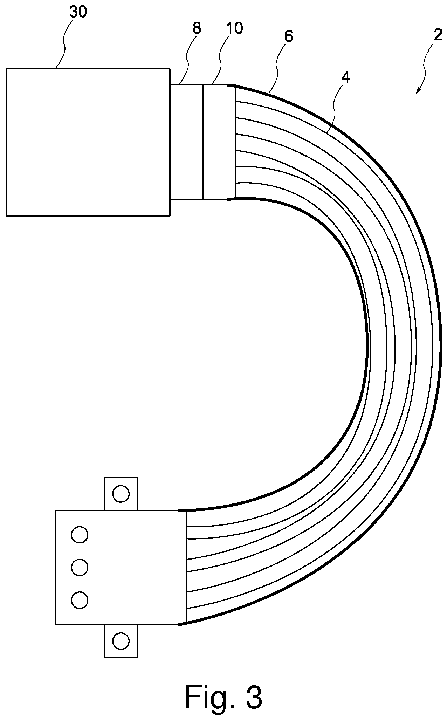

In Fig. 3 ist eine Komplettansicht des HV-Kabelsatzes 2 gezeigt. Deutlich erkennbar sind hier die drei von dem Schirm 6 umgebenen Kabel 4. Endseitig laufen die Kabel in eine HV-Komponente 30 ein. Hiervon ausgehend erstreckt sich das Anschlussstück 8, auf welches der Schirm 6 und die Klemmmanschette 10 aufgesetzt sind.

### Bezugszeichenliste

- 2: HV-Kabelsatz
- 4: Kabel
- 6: Schirm
- 8: Anschlussstück
- 10: Klemmmanschette
- 12: Schraube
- 14: Erste Klemmfläche
- 16: Stutzen
- 18: Flansch
- 20: Gewindeloch
- 22: Zweite Klemmfläche
- 24: Flansch
- 26: Durchgangsloch
- 30: HV-Komponente

- L: Längsrichtung
- R: Radiale Richtung
- W: Winkel

## Patentansprüche

1. HV-Kabelsatz (2), insbesondere für ein Fahrzeugbordnetz, mit einer Anzahl von Kabeln (4), die von einem gemeinsamen Schirm (6) umgeben sind, und mit einem Anschlussstück (8) aus einem leitenden Material, welches mit dem Schirm (6) elektrisch verbunden ist, indem eine Klemmmanschette (10) in einer Längsrichtung (L) auf das Anschlussstück (8) aufgeschoben ist und der Schirm (6) zwischen einer ersten Klemmfläche (14) des Anschlussstücks (8) und einer zweiten Klemmfläche (22) der Klemmmanschette (10) eingeklemmt ist,
**dadurch gekennzeichnet,**
**dass** die Klemmmanschette (10) mittels einer Anzahl von Schrauben (12) an dem Anschlussstück (8) befestigt ist und
**dass** die Schrauben (12) in Längsrichtung (L) in das Anschlussstück (8) eingeschraubt sind.

2. HV-Kabelsatz (2) nach dem vorhergehenden Anspruch,
**dadurch gekennzeichnet,**
**dass** die beiden Klemmflächen (14, 22) jeweils bezüglich der Längsrichtung (L) in einem Winkel (W) angestellt sind.

3. HV-Kabelsatz (2) nach einem der vorhergehenden Ansprüche,
**dadurch gekennzeichnet,**
**dass** die Klemmflächen (14, 22) komplementär zueinander ausgebildet sind.

4. HV-Kabelsatz (2) nach einem der vorhergehenden Ansprüche,
**dadurch gekennzeichnet,**
**dass** die Klemmflächen (14, 22) jeweils konisch ausgebildet sind.

5. HV-Kabelsatz (2) nach einem der vorhergehenden Ansprüche,
**dadurch gekennzeichnet,**
**dass** das Anschlussstück (8) und die Klemmmanschette (10) jeweils einen umlaufenden Flansch (18, 24) aufweisen.

6. HV-Kabelsatz (2) nach einem der vorhergehenden Ansprüche,
**dadurch gekennzeichnet,**
**dass** das Anschlussstück (8) und der Schirm (6) jeweils aus einem Material gefertigt sind, und die elektrochemischen Standardpotentiale der Materialien sich möglichst wenig, insbesondere um nicht mehr als 0,05 V unterscheiden.

7. HV-Kabelsatz (2) nach einem der vorhergehenden Ansprüche,
**dadurch gekennzeichnet,**
**dass** die Klemmmanschette (10) aus einem Material gefertigt ist, dessen elektrochemisches Standardpotential sich möglichst wenig, insbesondere um nicht mehr als 0,05 V von dem des Materials des Schirms (6) oder des Anschlussstücks (8) unterscheidet.

8. HV-Kabelsatz (2) nach einem der vorhergehenden Ansprüche,
**dadurch gekennzeichnet,**
**dass** die Klemmmanschette (10) als Tiefziehteil ausgebildet ist.

9. HV-Kabelsatz (2) nach einem der vorhergehenden Ansprüche,
**dadurch gekennzeichnet,**
**dass** dieser zusätzlich eine Gehäuseschale aufweist, welche die Klemmmanschette (10) einfasst.

10. HV-Kabelsatz (2) nach einem der vorhergehenden Ansprüche,
**dadurch gekennzeichnet,**
**dass** die erste Klemmfläche (10) eine aufgeraute Oberfläche aufweist, insbesondere mit einem Ra-Wert größer 0,4 µm.

11. HV-Kabelsatz (2) nach einem der vorhergehenden Ansprüche,
**dadurch gekennzeichnet,**
**dass** dieser über ein Anschlussteil (30) an einer elektrischen HV-Komponente eines Fahrzeugs angeschlossen ist.

## Claims

1. HV cable set (2), in particular for a vehicle electrical system, having a number of cables (4) which are surrounded by a common shield (6), and having a connection piece (8) which is made of a conductive material and is electrically connected to the shield (6) by virtue of a clamping sleeve (10) being pushed onto the connection piece (8) in a longitudinal direction (L) and the shield (6) being clamped between a first clamping surface (14) of the connection piece (8) and a second clamping surface (22) of the clamping sleeve (10),
**characterized**
**in that** the clamping sleeve (10) is fastened to the connection piece (8) by means of a number of screws (12), and
**in that** the screws (12) are screwed into the connection piece (8) in the longitudinal direction (L) .

2. HV cable set (2) according to the preceding claim,
**characterized**
**in that** the two clamping surfaces (14, 22) are each set at an angle (W) with respect to the longitudinal direction (L).

3. HV cable set (2) according to one of the preceding claims,
in that the clamping surfaces (14, 22) are complementary to one another.

4. HV cable set (2) according to one of the preceding claims,
**characterized**
**in that** the clamping surfaces (14, 22) are each conical.

5. HV cable set (2) according to one of the preceding claims,
**characterized**
**in that** the connection piece (8) and the clamping sleeve (10) each have a circumferential flange (18, 24).

6. HV cable set (2) according to one of the preceding claims,
**characterized**
**in that** the connection piece (8) and the shield (6) are each produced from a material, and the electrochemical standard potentials of the materials differ as little as possible, in particular by no more than 0.05 V.

7. HV cable set (2) according to one of the preceding claims,
**characterized**
**in that** the clamping sleeve (10) is produced from a material, the electrochemical standard potential of which differs as little as possible, in particular by no more than 0.05 V, from that of the material of the shield (6) or of the connection piece (8).

8. HV cable set (2) according to one of the preceding claims,
**characterized**
**in that** the clamping sleeve (10) is in the form of a deep-drawn part.

9. HV cable set (2) according to one of the preceding claims,
**characterized**
**in that** it additionally has a housing shell which surrounds the clamping sleeve (10).

10. HV cable set (2) according to one of the preceding claims,
**characterized**
**in that** the first clamping surface (14) has a roughened surface, in particular with an Ra value of greater than 0.4 µm.

11. HV cable set (2) according to one of the preceding claims,
**characterized**
**in that** it is connected to an electrical HV component of a vehicle via a connection part (30).

## Revendications

1. Faisceau de câbles de haute tension (2), notamment pour un réseau de bord de véhicule, avec un certain nombre de câbles (4) entourés par une gaine (6) commune, et avec une pièce de raccordement (8) réalisée à partir d'une matière conductrice reliée électriquement à la gaine (6) en enfonçant un manchon de serrage (10) sur la pièce de raccordement (8) dans une direction longitudinale (L) et la gaine (6) étant coincée entre une première surface de serrage (14) de la pièce de raccordement (8) et une deuxième surface de serrage (22) du manchon de serrage (10) ;
**caractérisé en ce que** :
le manchon de serrage (10) est fixé à la pièce de raccordement (8) à l'aide d'un certain nombre de vis (12) ; et
les vis (12) sont vissées dans la pièce de raccordement (8), dans la direction longitudinale (L).

2. Faisceau de câbles de haute tension (2) selon la revendication précédente, **caractérisé en ce que** les deux surfaces de serrage (14, 22) sont respectivement disposées selon un angle (W) par rapport à la direction longitudinale (L).

3. Faisceau de câbles de haute tension (2) selon l'une quelconque des revendications précédentes, **caractérisé en ce que** les surfaces de serrage (14, 22) sont réalisées de façon complémentaire l'une par rapport à l'autre.

4. Faisceau de câbles de haute tension (2) selon l'une quelconque des revendications précédentes, **caractérisé en ce que** les surfaces de serrage (14, 22) sont respectivement réalisées de façon conique.

5. Faisceau de câbles de haute tension (2) selon l'une quelconque des revendications précédentes, **caractérisé en ce que** la pièce de raccordement (8) et le manchon de serrage (10) comportent respectivement un flasque (18, 24) périphérique.

6. Faisceau de câbles de haute tension (2) selon l'une quelconque des revendications précédentes, **caractérisé en ce que** la pièce de raccordement (8) et la gaine (6) sont respectivement fabriquées à partir d'une matière et que les potentiels standard électrochimiques des matières se différencient le moins possible, notamment de tout au plus de 0,05 V.

7. Faisceau de câbles de haute tension (2) selon l'une quelconque des revendications précédentes, **caractérisé en ce que** le manchon de serrage (10) est fabriqué à partir d'une matière dont le potentiel standard électrochimique se différencie le moins possible, notamment de tout au plus 0,05 V, par rapport à la matière de la gaine (6) ou de la pièce de raccordement (8).

8. Faisceau de câbles de haute tension (2) selon l'une quelconque des revendications précédentes, **caractérisé en ce que** le manchon de serrage (10) est réalisé sous la forme d'une pièce d'emboutissage.

9. Faisceau de câbles de haute tension (2) selon l'une quelconque des revendications précédentes, **caractérisé en ce que** celui-ci comporte en outre une enveloppe de carter entourant le manchon de serrage (10) .

10. Faisceau de câbles de haute tension (2) selon l'une quelconque des revendications précédentes, **caractérisé en ce que** la première surface de serrage (14) comporte une surface brossée, notamment avec une valeur Ra supérieure à 0,4 µm.

11. Faisceau de câbles de haute tension (2) selon l'une quelconque des revendications précédentes, **caractérisé en ce que** celui-ci est relié à un composant électrique haute tension d'un véhicule via une partie de raccordement (30).
